# EUROPEAN PATENT SPECIFICATION

(11) **EP 1 227 577 B1**
(45) Date of publication and mention of the grant of the patent: **18.10.2006**
(21) Application number: 01200263.0
(22) Date of filing: 23.01.2001
(51) Int. Cl.: H03F 1/32, H03C 1/06, H03C 3/08, H03G 3/00

(54) **Method and apparatus for compensation of cross modulation effects**
Verfahren und Vorrichtung zur Kompensation von Kreuzmodulationseffekten
Procédé et dispositif de compensation des effets d'intermodulation

(43) Date of publication of application: 31.07.2002
(73) Proprietor: TELEFONAKTIEBOLAGET LM ERICSSON (publ), 164 83 Stockholm (SE)
(72) Inventor: Lindell, Bo, 181 46 Lidingö (SE)
(74) Representative: Herbjörnsen, Rut

(56) References cited:
- WO-A-00/10247
- US-A- 4 271 503
- US-A- 4 746 876
- US-A- 5 621 354

## Description

### Field of the invention

The present invention relates generally to the field of RF technology, and more particularly to a method and apparatus for cross modulation compensation.

### Background

Cross modulation distortion in RF amplifiers and mixers has been a well known phenomena for many years. RF amplifiers and mixers often show a non-linear behaviour when the input signal power exceeds a certain limit. This non-linear behaviour gives rise to cross modulation of the applied RF signals. An example of a situation where cross modulation occurs in an RF amplifier or mixer is when more than one radio signal, out of which at least one is amplitude modulated, is applied to the RF amplifier or mixer, and the total power on the device input exceeds the power limit above which the device does no longer respond linearly to incoming signals. If the amplitude modulated signal is strong, the amplitudes of the signals will be distorted; i.e. the signals will be cross modulated.

In radio systems where the wanted signal is not amplitude modulated and the amplitude hence does not carry any significant information, cross modulation is in most cases a minor problem. However, as soon as the amplitude of the wanted signal carries significant information, cross modulation can cause severe problems to the system.

Several techniques have been developed for cross modulation compensation in a non-linear RF device by controlling the power of the input signal in order to keep the working point of the non-linear device at a power level where the response is linear. In such techniques, the input signal will hence from time to time be attenuated. An example of such techniques is given in US5805979, where a synchronising signal is used for monitoring the power at an amplifier input. Another example of attenuating the input signal in response to changes in the input signal power is given in WO00/14887. However, in systems where the wanted signal can be expected to be weak compared to the disturbing signal, such as in radio receivers, attenuating the input signal would cause signal-to-noise ratios which are very likely to be unacceptable.

Another technique that is today used for avoiding cross modulation effects in RF amplifiers and mixers is to design devices with enough power handling capacity so that the power limit for linear response will seldom be exceeded. However, such RF amplifiers and mixers have a high power consumption. For various reasons, such as problems of keeping electronic equipment cool and a wish to cut the cost of the electrical power, it is desirable to reduce the power consumption of RF devices. A method and apparatus for reducing effects of cross modulations in amplifiers and mixers, without attenuating or modulating the input signal, while keeping the amplifier or mixer power consumption at a low level, would therefore be of great importance to users of weak RF signals.

### Summary

An object of the invention is to reduce the effects of cross modulation in RF devices where cross modulation appears, here referred to as amplifiers or mixers, without having to attenuate or modulate the RF signal prior to applying the RF signal to the amplifier or mixer.

According to the invention, this has been solved by a method for reducing the effects of cross modulation of an RF signal applied to an amplifier or mixer, in which method a test signal is generated. The test signal and the RF signal are then simultaneously applied to the amplifier or mixer. The amplified or mixed test signal is detected and the amplitude modulation of the amplified or mixed test signal is then measured. A test signal AM detector output, representing the result obtained in the measurement, is then generated and used for cross modulation compensation of the RF signal.

The objects of the invention are further met by an electronic circuit for cross modulation compensation of an RF signal applied to an amplifier or mixer forming a part of the electronic circuit. The electronic circuit comprises, in addition to the amplifier or mixer, a test signal generator for generating a test signal to be applied, simultaneously to the RF signal, to the amplifier or mixer. The electronic circuit further comprises a test signal filter operable on an extracted part of the amplified or mixed RF signal in order to filter out the amplified or mixed test signal, cross modulation compensating means for cross modulation compensating the amplified or mixed RF signal and a test signal AM detector. The test signal AM detector detects the amplified or mixed test signal and measures the amplitude modulation of the amplified or mixed test signal. The test signal AM detector then generates a test signal AM detector output representing the results obtained in the measurement. This test signal AM detector output is then used for cross modulation compensation of the amplified or mixed RF signal in the cross modulation compensating means.

By the method and electronic circuit of the invention is achieved that cross modulation compensation of an RF signal applied to an amplifier or mixer can be performed without having to attenuate or modulate the RF signal prior to applying the RF signal to the amplifier or mixer, thus avoiding to deteriorate the signal-to-noise ratio by attenuating or modulating the RF signal at the amplifier or mixer output.

According to one aspect of the present invention the cross modulation compensating means comprises a signal processor, in which the cross modulation of the RF signal by use of the test signal AM detector output is performed digitally.

According to another aspect of the invention, cross modulation compensation of the RF signal is performed by amplitude modulating the amplified or mixed RF signal, the amplitude modulation being determined by the test signal AM detector output. In one embodiment of the invention, the amplitude modulation of the RF signal is performed in a closed loop where the test signal AM detector output is kept at a constant value.

According to yet another aspect of the invention, in which the amplifier or mixer comprises a mixer to which is associated a local oscillator generating a local oscillator signal, the test signal is mixed with the local oscillator signal at a test signal first mixer prior to being applied to the mixer. Hereby is achieved that the frequency of the mixed test signal is kept at a constant value regardless of whether the frequency of the local oscillator signal is varied or not.

### Brief description of the drawings

The present invention will now be discussed in more detail with reference to preferred embodiments of the present invention, given only by way of example, and illustrated in the accompanying drawings, in which:
Fig. 1 illustrates an example of an amplifier circuit where cross modulation compensation is performed according to one embodiment of the present invention.
Fig. 2 also illustrates an example of an amplifier circuit where cross modulation compensation is performed according to another embodiment of the present invention.
Fig. 3 is an electronic circuit used for keeping the output test signal frequency constant when the method of the invention is applied to a circuit comprising a mixer.
Fig. 4 is an exemplary electronic circuit where cross modulation compensation is performed on an RF signal applied to a series of an RF amplifier and a mixer according to the embodiment shown in Fig. 1. The method of Fig. 3 is also applied.

### Detailed description

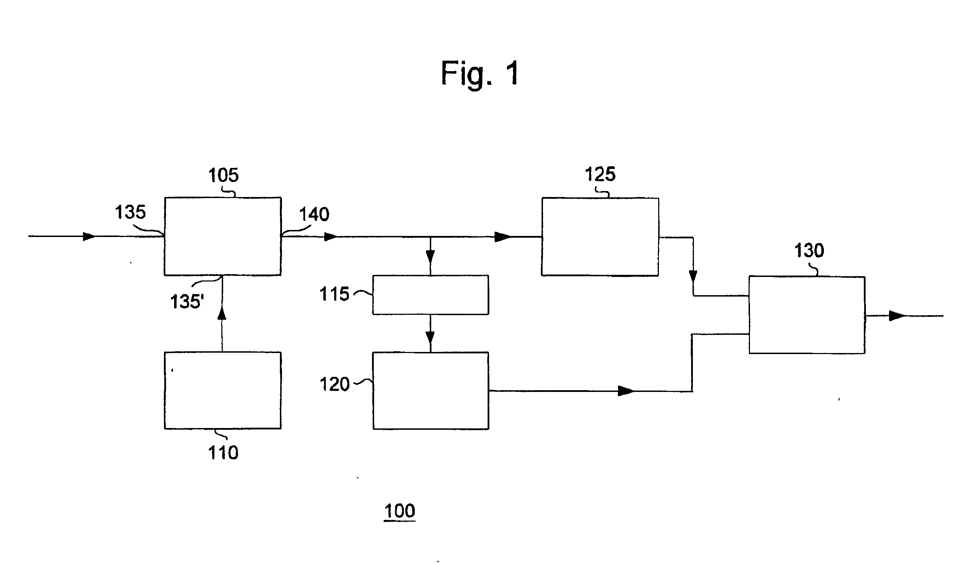

An example of an electronic circuit which could advantageously be used for reducing the effects of cross modulation of RF signals in an RF amplifier is schematically shown in Fig. 1. The method for cross modulation compensation used in electronic circuit 100 shown in Fig. 1 could also be used for cross modulation compensation in non-linear RF devices other than RF amplifiers, such as e.g. mixers or switches, as well as to any series of non-linear RF devices giving rise to cross modulation. In the following, the term "amplifier or mixer" will be used when generally referring to a non-linear RF device giving rise to cross modulation.

Electronic circuit 100 comprises an RF amplifier 105, or more simply an amplifier 105, a test signal generator 110, a test signal filter 115, a test signal amplitude modulation (AM) detector 120, a wanted signal AM detector 125 and a signal processor 130. The wanted RF signal, or simply the wanted signal, is fed to an input 135 of the amplifier 105. At the same time, a test signal generated by the test signal generator 110 is fed to an input 135' of the amplifier 105. Advantageously, the power level of the test signal should be low in order to avoid disturbances to the system caused by the test signal. Depending on the test signal frequency chosen and the location of the amplifier bandpass filter, the amplifier input 135' could possibly be identical to amplifier input 135.

At the output 140 of amplifier 105 part of the signal is extracted and fed, via test signal filter 115 that filters out the test signal, into test signal AM detector 120. Test signal AM detector 120 detects the amplified test signal and measures the amplitude modulation of the test signal. Test signal AM detector 120 then generates a test signal AM detector output representing the measured amplitude modulation. The test signal AM detector output is then fed into the signal processor 130, where it can be used for cross modulation compensation of the wanted signal. Since the amplitude of the test signal generated by test signal generator 110 is constant, and the test signal experiences amplitude modulation in amplifier 105, the test signal AM detector output represents a value of the instantaneous cross modulation that the signals applied to amplifier 105 experiences in amplifier 105.

The amplified signal at the amplifier output 140 is detected and analysed in wanted signal AM detector 125. The amplitude modulation of the amplified signal is measured, and the wanted signal AM detector 125 generates a wanted signal AM detector output representative of the wanted signal amplitude modulation. This wanted signal AM detector output represents the combination of the significant AM modulation of the wanted signal and the disturbing cross modulation of the wanted signal. The wanted signal AM detector output is then fed into signal processor 130, where the test signal AM detector output is used for cross modulation compensation of the wanted signal AM detector output. The wanted signal AM detector output is preferably multiplied by the inverted value of the amplitude modulation of the test signal, represented by the test signal AM detector output, on an instantaneous basis. In this way, the signal processor 130 can obtain an instantaneous value of the amplitude modulation of the wanted signal where the disturbing cross modulation has to a great extent been compensated for.

When the conditions in the amplifier are such that cross modulation occurs, all signals applied to the amplifier 105, including the test signal, will be subject to cross modulation. If the test signal frequency is close to the frequency of the wanted signal, the amplitude distortion of the two signals caused by cross modulation will be very similar. However, in some cases it might be preferable to use a test signal frequency which is well separated from the frequency of the wanted signal, e.g. if intermodulation distortion caused by intermodulation of the test signal with other signals applied to the amplifier should be kept at a minimum. In such cases, there will still be a relationship between the amplitude modulation experienced by the test signal and that experienced by the wanted signal.

When the test frequency used is significantly different to the wanted signal frequency, the relationship between the amplitude modulation experienced by the test signal in the amplifier 105 and that experienced by the wanted signal can be used as an input to the compensation algorithm used by signal processor 130. This relationship could be measured and stored at a memory in the signal processor 130 prior to performing the cross modulation compensation, possibly by a learning procedure.

Instead of detecting the amplitude modulation of the test signal in an analogue test signal AM detector 120, the test signal could be fed directly (via test signal filter 115) to signal processor 130 for digital detection of the amplitude modulation. The amplitude modulation could alternatively be digitally detected externally to the signal processor 130. The wanted signal AM detector 125 could similarily be exchanged for digital amplitude modulation detection in signal processor 130. Other modifications of electronic circuit 100 may also be made without deviating from the spirit of the invention. For example, a bandpass filter could advantageously be used in the electronic circuit 100 in order to filter out the amplified wanted signal at the amplifier output 140 prior to transmitting the signal into the wanted signal AM detector 125.

Cross modulation can cause phase distortions as well as amplitude distortions in a wanted signal. When a constant relation between the amplitude and phase distortions of the wanted signal exists, distortion of the wanted signal in the phase domain could be compensated for in signal processor 130 by use of the test signal AM detector output. When the wanted signal is Phase Modulated (PM), the wanted signal AM detector could then be exchanged for a wanted signal PM detector, capable of generating a wanted signal PM detector output. Cross modulation compensation of an RF signal could simultaneously be performed in the phase and amplitude domains.

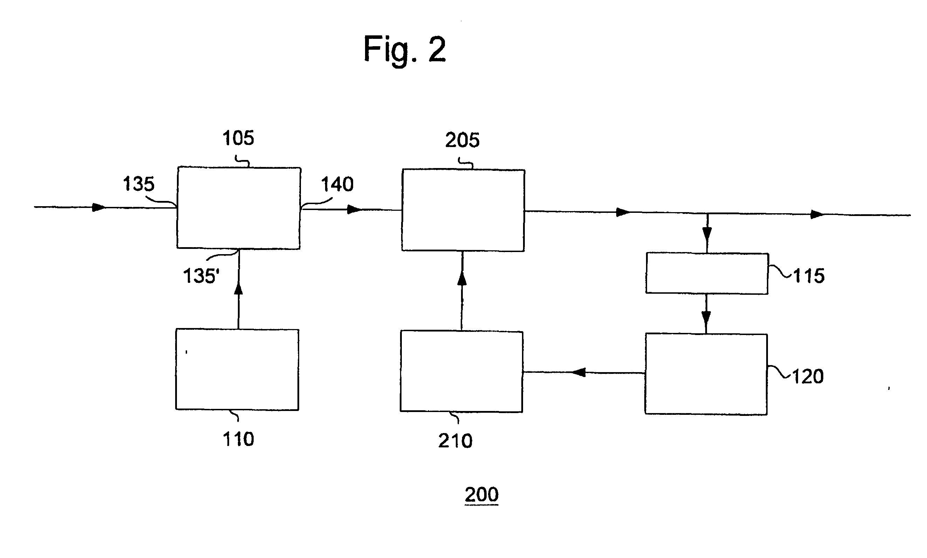

In Fig. 2, another embodiment of the present invention is shown. An exemplary electronic circuit 200 which could be used for cross modulation compensation of an amplified RF signal comprises amplifier 105, test signal generator 110, test signal filter 115, test signal AM detector 120, an amplitude modulator 205 and a control loop amplifier 210. Amplitude modulator 120 could be exchanged for a variable attenuator or similar device. For the purpose of illustration the exemplary electronic circuit 200 is used for cross modulation compensation of an RF signal applied to an amplifier 105, but the method used in electronic circuit 200 could also be used for cross modulation compensation in any other amplifier or mixer.

The amplifier 105 is fed with the wanted signal and a test signal generated by the test signal generator 110. Should the conditions for when cross modulation occurs be fulfilled, the test signal as well as the wanted signal would experience cross modulation in amplifier 105. The amplified signal on the amplifier output 140 is then transmitted via the amplitude modulator 205. At the output of amplitude modulator 205, part of the signal is extracted and transmitted through the test signal filter 115 where the amplified test signal is filtered out. The amplified test signal is then fed into the test signal AM detector 120. Test signal AM detector 120 generates a test signal AM detector output, representative of the amplitude modulation of the amplified test signal. Test signal AM detector output is fed into the control loop amplifier 210, which is a regulating device that regulates the amplitude modulator 205 operable on the amplified signal at the amplifier output 140. The reference value of the test signal amplitude detector output used by the control loop amplifier 210 is kept at a constant value. Hence, the closed automatic control loop of electronic circuit 200 keeps the amplitude of the test signal at the output of amplitude modulator 205 at a constant value, regardless of any cross modulation. Since the amplitude modulator 205 is regulated on the basis of amplitude modulation of the test signal rather than amplitude modulation of the wanted signal, the test signal frequency used in electronic circuit 200 should preferably be in the pass band of the amplifier 105, so that the cross modulation of the two signals are as similar as possible. The output of the amplitude modulator 205 will hence be the amplified RF signal which has to a great extent been cross modulation compensated.

In electronic circuit 200, the control loop amplifier 210 could be omitted and the test signal AM detector output could be fed directly into amplitude modulator 205, where the amplified signal is then multiplied by the inverse value of the detected amplitude of the test signal, where the numerical value of the detected undisturbed test signal is set to one. The test signal should in this embodiment be extracted and fed into test signal AM detector 120 via test signal filter 115 directly at the amplifier output 140, before the amplified signal enters the amplitude modulator 205, in order to avoid any further modulation of the test signal. In this embodiment, it its preferable that the amplitude modulator 205 and the test signal AM detector 120 both show a linear behaviour in the relevant frequency and power regions.

When the principles of electronic circuits 100 and 200 are applied to cross modulation compensation in a mixer, special precaution may have to be taken since a mixer converts the input signal frequency to an intermediate frequency by mixing the signal with a local oscillator signal. In e.g. a multi-channel receiver, the frequency of the local oscillator signal is varied when the receiver is tuned, and hence, if no special action is taken, the frequency of the test signal at the mixer output also varies. For various reasons, it is preferable to use a constant frequency in the test frequency filter 115 and the test frequency AM detector 120. It would therefore be desirable to keep the output test signal frequency constant as the receiver is tuned.

One way to obtain a constant frequency of the output test signal could be to vary the frequency of the input test signal in accordance with the variations in the local oscillator frequency as the receiver is tuned, i.e. to keep the difference in frequency between the test signal and the local oscillator at a constant value, equal to the frequency to which the test signal filter 115 and test signal AM detector 120 are optimised. This could be obtained by the use of a frequency synthesiser.

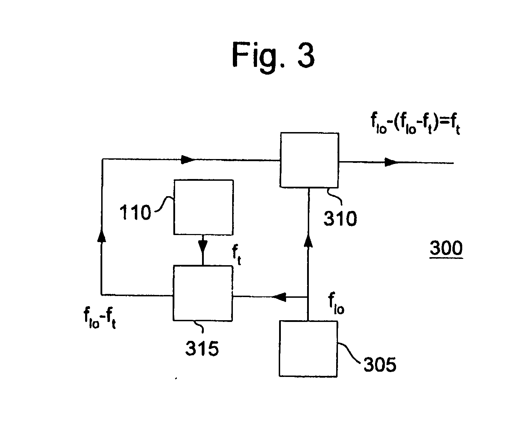

An example of an electronic circuit which uses another method for keeping the output test signal frequency constant even when the frequency of the local oscillator in a mixer is varied is shown in Fig. 3. In addition to the test frequency generator 110, the electronic circuit 300 comprises a local oscillator 305, a mixer 310 and a test frequency first mixer 315. In the test frequency first mixer 315, the test signal of frequency fₜ generated by the test frequency generator 110 is first mixed with the local oscillator signal of frequency fₗₒ, to obtain the frequencies (fₗₒ-fₜ) and (fₗₒ+fₜ). One of the frequencies is then filtered out and used as the test signal; in Fig. 3 the frequency (fₗₒ-fₜ) is chosen. When the test signal is then applied to mixer 310, it is once again mixed with the local oscillator signal. In the example shown in Fig. 3, the frequency of the test signal hereby obtained is (fₗₒ-(fₗₒ-fₜ))=fₜ, which is the desired result of a test signal frequency which does not depend on the frequency of the local oscillator.

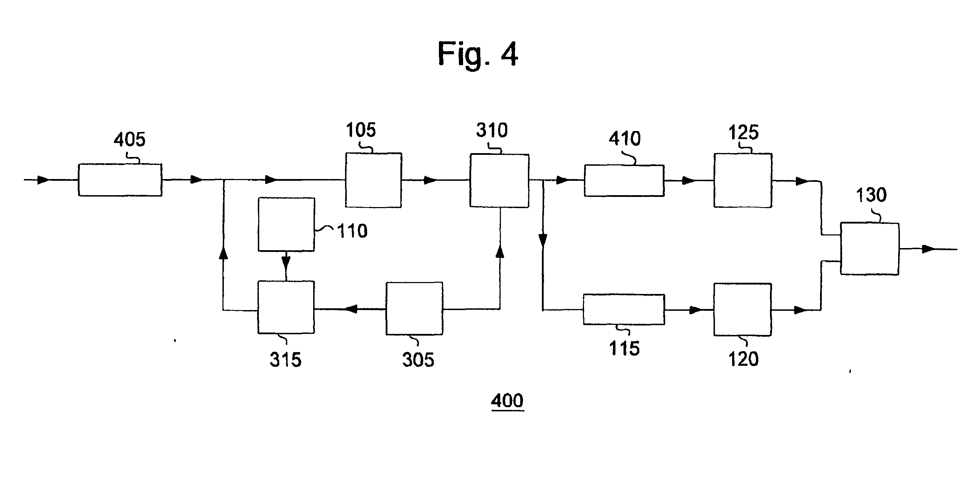

An exemplary electronic circuit 400 is shown in Fig. 4, where cross modulation compensation according to the embodiment of the invention shown in Fig. 1 is applied to a series of amplifiers or mixers. An electronic circuit 400 comprises amplifier 105, mixer 310, local oscillator 305, test signal first mixer 315, test signal generator 110, test signal filter 115, test signal AM detector 120, wanted signal AM detector 125, signal processor 130, bandpass filter 405 and intermediate frequency filter 410.

The test signal is generated at the input of the non-linear series, and filtered out and analysed at the series output. To avoid alterations in the output test signal frequency caused by mixer 310, the test signal generated by test signal generator 110 is first mixed with the local oscillator signal in the test frequency first mixer 315 in accordance with the method shown in Fig. 3. The test signal is then transmitted on the same path as the wanted signal, which has previously been fed through bandpass filter 405. The two signals are applied to the amplifier 105 and the mixer 310, and hence the test signal experiences the same cross modulation as the wanted signal. At the output of mixer 310, part of the signal is extracted and fed via test signal filter 115 into test signal AM detector 120. In test signal AM detector 120 the test signal is detected and its amplitude modulation is measured. The result hereby obtained determines the test signal AM detector output which is transmitted to signal processor 130. The wanted signal is fed to the wanted signal AM detector 125 via an intermediate frequency filter 410. The wanted signal AM detector 125 detects the wanted signal, measures its amplitude modulation and generates a wanted signal AM detector output which represents the measured amplitude modulation of the wanted signal. The wanted signal AM detector output is then fed into the signal processor 130, where the test signal AM detector output is used for cross modulation compensation of the wanted signal AM detector output. The output of signal processor 130 hence represents the significant amplitude modulation of the wanted signal.

Instead of having a separate test signal generator in Fig. 4, a signal from the local oscillator 305 could be used as the test signal. This would be analogous to setting the test signal frequency generated by the test signal generator 110 to zero.

The inventive method and apparatus could advantageously be used for cross modulation compensation in RF systems where the wanted signal is expected to be weak compared to the modulating signal. An example of such systems is radio receivers. However, the invention could also successfully be applied to RF systems where the wanted signal is not expected to be weak. In some cases, amplitude modulation caused by cross modulation could cause problems to systems where the wanted signal is not amplitude modulated. The method of the invention could then advantageously be applied to such systems, and electronic circuits analogous to the ones presented in Fig. 1-4 could be used. The wanted signal AM detector 125, shown in Figs. 1 and 4, would then be omitted.

One skilled in the art will appreciate that the present invention is not limited to the embodiments disclosed in the accompanying drawings and the foregoing detailed description, which are presented for purposes of illustration only, but it can be implemented in a number of different ways, and it is defined by the following claims.

## Claims

1. A method for reducing the effects of cross modulation of an RF signal applied to an amplifier or mixer (105,310), the amplifier or mixer (105,310) operable in a pass band, the method **characterised by** the following steps:
generating a test signal;
simultaneously applying the RF signal and the test signal to said amplifier or mixer (105,310) in order to obtain an amplified or mixed RF signal and an amplified or mixed test signal;
detecting the amplified or mixed test signal;
measuring the amplitude modulation of the amplified or mixed test signal;
generating a test signal AM detector output representing the amplitude modulation measured in the step of measuring;
compensating the amplified or mixed RF signal for cross modulation effects by using said test signal AM detector output.

2. The method according to claim 1, further **characterised in that** the frequency of the test signal lies substantially within the amplifier or mixer pass band.

3. The method according to claim 1, further **characterised in that** the frequency of the test signal lies outside of the amplifier or mixer pass band.

4. The method according to claim 1, further **characterised in that** the step of compensating is performed digitally in a signal processor (130).

5. The method according to claim 4, further **characterised by**
measuring the amplitude modulation of the RF signal prior to the step of compensating, resulting in an AM detected RF signal; and in that
the step of compensating is performed on said AM detected RF signal.

6. The method according to claim 5, further **characterised in that** the steps of measuring the amplitude modulations of the RF signal and the test signal are performed by use of analogue equipment (125, 120) external to the signal processor (130).

7. The method according to claim 5, further **characterised in that** the steps of measuring the amplitude modulations of the RF signal and the test signal are performed digitally.

8. The method according to claim 4, further **characterised by**
measuring the phase modulation of the RF signal prior to the step of compensating, resulting in a PM detected RF signal; and in that
the step of compensating is performed on said PM detected RF signal.

9. The method according to claims 3 and 4, further **characterised by** the following steps:
measuring the relationship between the cross modulation experienced by the RF signal and the cross modulation experienced by the test signal when subject to the same disturbing signal in the amplifier or mixer (105,310);
storing said relationship in a memory accessible to the signal processor (130); and
using this relationship in combination with the test signal AM detector output in the step of compensating.

10. The method according to claim 1, further **characterised in that** the step of compensating further comprises the step of amplitude modulating the amplified or mixed RF signal, the applied amplitude modulation being determined by use of the test signal AM detector output.

11. The method according to claim 10, further **characterised in that** the step of amplitude modulating is performed in a closed automatic control loop where the test signal AM detector output is kept at a constant value.

12. The method according to claim 10, further **characterised in that** the step of amplitude modulating is performed by multiplying the amplified or mixed RF signal by the instantaneous value of the inverse of the measured amplitude modulation of the amplified or mixed test signal.

13. The method according to claim 1, wherein the amplifier or mixer (105, 310) is a mixer (310) to which is associated a local oscillator (305) generating a local oscillator signal, further **characterised by** the following step:
mixing the test signal with the local oscillator signal at a test signal first mixer (315) prior to applying the test signal to the mixer (305).

14. An electronic circuit for cross modulation compensation of an RF signal, the RF signal applied to an amplifier or mixer (105,310) forming a part of the electronic circuit, the electronic circuit **characterised by**:
a test signal generator (110) for generating a test signal to be applied, simultaneously to the RF signal, to the amplifier or mixer (105, 310);
a test signal filter (115) operable on an extracted part of the amplified or mixed RF signal for filtering out the amplified or mixed test signal;
a test signal AM detector (120) for detecting the amplified or mixed test signal at the output of the test signal filter and for measuring the amplitude modulation of the amplified or mixed test signal, the test signal AM detector (120) capable of generating a test signal AM detector output representing the amplitude modulation of the amplified or mixed test signal; and
cross modulation compensating means (130, 205) for cross modulation compensating the amplified or mixed RF signal by use of said test signal AM detector output.

15. The electronic circuit of claim 14, further **characterised in that** the cross modulation compensating means comprises a signal processor (130).

16. The electronic circuit of claim 15, further **characterised by**
a wanted signal AM detector (125) for detecting the amplified or mixed RF signal and for measuring the amplitude modulation of the amplified or mixed RF signal, the wanted signal AM detector (125) capable of generating and forwarding to the signal processor (130) a wanted signal AM detector output representing the amplitude modulation of the amplified or mixed RF signal.

17. The electronic circuit of claim 16, further **characterised in that** the test signal AM detector (120) and the wanted signal AM detector (125) are analogue devices external to the signal processor (130).

18. The electronic circuit of claim 16, further **characterised in that** the test signal AM detector (120) and the wanted signal AM detector (125) are digitally implemented.

19. The electronic circuit of claim 15, further **characterised by**
a wanted signal PM detector (125) for detecting the amplified or mixed RF signal and for measuring the phase modulation of the amplified or mixed RF signal, the wanted signal PM detector (125) capable of generating and forwarding to the signal processor (130)a wanted signal PM detector output representing the phase modulation of the amplified or mixed RF signal.

20. The electronic circuit of claim 15, wherein the test signal generator (110) generates a test signal of a frequency which lies outside of the amplifier or mixer passband, the electronic circuit further **characterised by**
a storage for storing a relationship between the cross modulation experienced by the RF signal and the cross modulation experienced by the test signal when subject to the same disturbing signal in the amplifier or mixer, said storage being accessible to the signal processor (130).

21. The electronic circuit of claim 14, further **characterised in that** the cross modulating compensation means comprises an amplitude modulator (205) operable on the amplified or mixed RF signal, the amplitude modulation performed by the amplitude modulator (205) being determined by use of the test signal AM detector output.

22. The electronic circuit of claim 14, further **characterised in that** the amplitude modulation performed by the amplitude modulator (205) is automatically controlled in a closed loop, comprising a control loop amplifier (210), where the test signal AM detector output is kept at a constant value.

23. The electronic circuit of claim 14, wherein the amplifier or mixer (105, 310) is a mixer (310) to which is associated a local oscillator (305) generating a local oscillator signal, further **characterised by**
a test signal first oscillator (315) for mixing the test signal with the local oscillator signal prior to applying the test signal to the mixer (310).

24. The electronic circuit of claim 14, further **characterised in that** the amplifier or mixer (105, 310) is part of a radio receiver.

## Patentansprüche

1. Verfahren zum Verringern der Effekte der Kreuzmodulation auf ein HF-Signal, das in einen Verstärker oder Mischer (105, 310) eingespeist wird, wobei der Verstärker oder Mischer (105, 310) in einem Durchlassband arbeitet, wobei das Verfahren durch die folgenden Schritte **gekennzeichnet** ist:
Erzeugen eines Testsignals;
gleichzeitiges Einspeisen des HF-Signals und des Testsignals in den Verstärker oder Mischer (105, 310), um ein verstärktes oder gemischtes HF-Signal und ein verstärktes oder gemischtes Testsignal zu erhalten;
Detektieren des verstärkten oder gemischten Testsignals;
Messen der Amplitudenmodulation des verstärkten oder gemischten Testsignals;
Erzeugen eines Testsignal-AM-Detektor-Ausgangs, der die in dem Messschritt gemessene Amplitudenmodulation darstellt;
Kompensieren des verstärkten oder gemischten HF-Signals um Kreuzmodulationseffekte unter Verwendung des Testsignal-AM-Detektor-Ausgangs.

2. Verfahren nach Anspruch 1, des Weiteren **dadurch gekennzeichnet, dass** die Frequenz des Testsignals im Wesentlichen innerhalb des Durchlassbandes des Verstärkers oder Mischers liegt.

3. Verfahren nach Anspruch 1, des Weiteren **dadurch gekennzeichnet, dass** die Frequenz des Testsignals außerhalb des Durchlassbandes des Verstärkers oder Mischers liegt.

4. Verfahren nach Anspruch 1, des Weiteren **dadurch gekennzeichnet, dass** der Schritt des Kompensierens digital in einem Signalprozessor (130) ausgeführt wird.

5. Verfahren nach Anspruch 4, des Weiteren **gekennzeichnet durch**:
Messen der Amplitudenmodulation des HF-Signals vor dem Schritt des Kompensierens, was zu einem AM-detektierten HF-Signal führt; und **dadurch**, dass
der Schritt des Kompensierens an dem AM-detektierten HF-Signal durchgeführt wird.

6. Verfahren nach Anspruch 5, des Weiteren **dadurch gekennzeichnet, dass** die Schritte des Messens der Amplitudenmodulationen des HF-Signals und des Testsignals unter Verwendung analoger Ausrüstung (125, 120), die außerhalb des Signalsprozessors (130) liegt, ausgeführt werden.

7. Verfahren nach Anspruch 5, des Weiteren **dadurch gekennzeichnet, dass** die Schritte des Messens der Amplitudenmodulationen des HF-Signals und des Testsignals digital ausgeführt werden.

8. Verfahren nach Anspruch 4, des Weiteren **gekennzeichnet durch**:
Messen der Phasenmodulation des HF-Signals vor dem Schritt des Kompensierens, was zu einem PM-detektierten HF-Signal führt; und **dadurch**, dass
der Schritt des Kompensierens an dem PM-detektierten HF-Signal ausgeführt wird.

9. Verfahren nach den Ansprüchen 3 und 4, des Weiteren **gekennzeichnet durch** die folgenden Schritte:
Messen der Beziehung zwischen der Kreuzmodulation, die auf das HF-Signal einwirkt, und der Kreuzmodulation, die auf das Testsignal einwirkt, wenn sie demselben Störsignal in dem Verstärker oder Mischer (105, 310) ausgesetzt werden;
Speichern der Beziehung in einem Speicher, auf den der Signalprozessor (130) zugreifen kann; und
Verwenden dieser Beziehung in Kombination mit dem Testsignal-AM-Detektor-Ausgang in dem Schritt des Kompensierens.

10. Verfahren nach Anspruch 1, des Weiteren **dadurch gekennzeichnet, dass** der Schritt des Kompensierens des Weiteren den Schritt des Amplitudenmodulierens des verstärkten oder gemischten HF-Signals umfasst, wobei die ausgeführte Amplitudenmodulation unter Verwendung des Testsignal-AM-Detektor-Ausgangs bestimmt wird.

11. Verfahren nach Anspruch 10, des Weiteren **dadurch gekennzeichnet, dass** der Schritt des Amplitudenmodulierens in einem geschlossenen automatischen Steuerkreis ausgeführt wird, wobei der Testsignal-AM-Detektor-Ausgang auf einem konstanten Wert gehalten wird.

12. Verfahren nach Anspruch 10, des Weiteren **dadurch gekennzeichnet, dass** der Schritt des Amplitudenmodulierens durch Multiplizieren des verstärkten oder gemischten HF-Signals mit dem momentanen Wert des Inversen der gemessenen Amplitudenmodulation des verstärkten oder gemischten Testsignals ausgeführt wird.

13. Verfahren nach Anspruch 1, wobei der Verstärker oder Mischer (105, 310) ein Mischer (310) ist, dem ein Überlagerungsoszillator (305) zugeordnet ist, der ein Überlagerersignal erzeugt, des Weiteren **gekennzeichnet durch** den folgenden Schritt:
Mischen des Testsignals mit dem Überlagerersignal in einem ersten Testsignalmischer (315) vor dem Einspeisen des Testsignals in den Mischer (305).

14. Elektronischer Schaltkreis zur Kreuzmodulationskompensation eines HF-Signals, wobei das HF-Signal in einen Verstärker oder Mischer (105, 310) eingespeist wird, der einen Teil des elektronischen Schaltkreises bildet, wobei der elektronische Schaltkreis **gekennzeichnet ist durch**:
einen Testsignalgenerator (110) zum Erzeugen eines Testsignals, das gleichzeitig mit dem HF-Signal in den Verstärker oder Mischer (105, 310) einzuspeisen ist;
einen Testsignalfilter (115), der auf einen extrahierten Abschnitt des verstärkten oder gemischten HF-Signals wirkt, zum Herausfiltern des verstärkten oder gemischten Testsignals;
einen Testsignal-AM-Detektor (120) zum Detektieren des verstärkten oder gemischten Testsignals am Ausgang des Testsignalfilters und zum Messen der Amplitudenmodulation des verstärkten oder gemischten Testsignals, wobei der Testsignal-AM-Detektor (120) in der Lage ist, einen Testsignal-AM-Detektor-Ausgang zu erzeugen, der die Amplitudenmodulation des verstärkten oder gemischten Testsignals darstellt; und
ein Kreuzmodulationskompensationsmittel (130, 205) zum Kreuzmodulationskompensieren des verstärkten oder gemischten HF-Signals unter Verwendung des Testsignal-AM-Detektor-Ausgangs.

15. Elektronischer Schaltkreis nach Anspruch 14, des Weiteren **dadurch gekennzeichnet, dass** das Kreuzmodulationskompensationsmittel einen Signalprozessor (130) umfasst.

16. Elektronischer Schaltkreis nach Anspruch 15, des Weiteren **gekennzeichnet durch**:
einen Nutzsignal-AM-Detektor (125) zum Detektieren des verstärkten oder gemischten HF-Signals und zum Messen der Amplitudenmodulation des verstärkten oder gemischten HF-Signals, wobei der Nutzsignal-AM-Detektor (125) in der Lage ist, einen Nutzsignal-AM-Detektor-Ausgang zu erzeugen und an den Signalprozessor (130) weiterzuleiten, der die Amplitudenmodulation des verstärkten oder gemischten HF-Signals darstellt.

17. Elektronischer Schaltkreis nach Anspruch 16, des Weiteren **dadurch gekennzeichnet, dass** der Testsignal-AM-Detektor (120) und der Nutzsignal-AM-Detektor (125) analoge Vorrichtungen sind, die sich außerhalb des Signalprozessors (130) befinden.

18. Elektronischer Schaltkreis nach Anspruch 16, des Weiteren **dadurch gekennzeichnet, dass** der Testsignal-AM-Detektor (120) und der Nutzsignal-AM-Detektor (125) digital implementiert sind.

19. Elektronischer Schaltkreis nach Anspruch 15, des Weiteren **gekennzeichnet durch**:
einen Nutzsignal-PM-Detektor (125) zum Detektieren des verstärkten oder gemischten HF-Signals und zum Messen der Phasenmodulation des verstärkten oder gemischten HF-Signals, wobei der Nutzsignal-PM-Detektor (125) in der Lage ist, einen Nutzsignal-PM-Detektor-Ausgang zu erzeugen und an den Signalprozessor (130) weiterzuleiten, der die Phasenmodulation des verstärkten oder gemischten HF-Signals darstellt.

20. Elektronischer Schaltkreis nach Anspruch 15, wobei der Testsignalgenerator (110) ein Testsignal mit einer Frequenz erzeugt, die außerhalb des Durchlassbandes des Verstärkers oder Mischers liegt, wobei der elektronische Schaltkreis des Weiteren **gekennzeichnet ist durch**:
einen Speicher zum Speichern einer Beziehung zwischen der Kreuzmodulation, die auf das HF-Signal einwirkt, und der Kreuzmodulation, die auf das Testsignal einwirkt, wenn sie demselben Störsignal in dem Verstärker oder Mischer ausgesetzt werden, wobei auf diesen Speicher durch den Signalprozessor (130) zugegriffen werden kann.

21. Elektronischer Schaltkreis nach Anspruch 14, des Weiteren **dadurch gekennzeichnet, dass** das Kreuzmodulationskompensationsmittel einen Amplitudenmodulator (205) umfasst, der auf das verstärkte oder gemischte HF-Signal wirkt, wobei die durch den Amplitudenmodulator (205) ausgeführte Amplitudenmodulation unter Verwendung des Testsignal-AM-Detektor-Ausgangs bestimmt wird.

22. Elektronischer Schaltkreis nach Anspruch 14, des Weiteren **dadurch gekennzeichnet, dass** die durch den Amplitudenmodulator (205) ausgeführte Amplitudenmodulation automatisch in einem geschlossenen Kreis gesteuert wird, der einen Steuerkreisverstärker (210) umfasst, wobei der Testsignal-AM-Detektor-Ausgang auf einem konstanten Wert gehalten wird.

23. Elektronischer Schaltkreis nach Anspruch 14, wobei der Verstärker oder Mischer (105, 310) ein Mischer (310) ist, dem ein Überlagerungsoszillator (305) zugeordnet ist, der ein Überlagerersignal erzeugt, des Weiteren **gekennzeichnet durch**:
einen ersten Testsignaloszillator (315) zum Mischen des Testsignals mit dem Überlagerersignal vor dem Einspeisen des Testsignals in den Mischer (310).

24. Elektronischer Schaltkreis nach Anspruch 14, des Weiteren **dadurch gekennzeichnet, dass** der Verstärker oder Mischer (105, 310) Teil eines Funkempfängers ist.

## Revendications

1. Procédé pour réduire les effets de transmodulation d'un signal RF appliqué à un amplificateur ou mélangeur (105, 310), l'amplificateur ou mélangeur (105, 310) pouvant être mis en oeuvre dans une bande passante, le procédé étant **caractérisé par** les étapes suivantes qui consistent :
à générer un signal de test :
à appliquer simultanément le signal RF et le signal de test audit amplificateur ou mélangeur (105, 310) pour obtenir un signal RF amplifié ou mélangé et un signal de test amplifié ou mélangé ;
à détecter le signal de test amplifié ou mélangé ;
à mesurer la modulation d'amplitude du signal de test amplifié ou mélangé ;
à générer un signal de sortie de détecteur AM de signal de test représentant la modulation d'amplitude mesurée dans l'étape de mesure ;
à compenser des effets de transmodulation du signal RF amplifié ou mélangé en utilisant ledit signal de sortie du détecteur AM du signal de test.

2. Procédé selon la revendication 1, **caractérisé en outre en ce que** la fréquence du signal de test est comprise sensiblement dans la bande passante de l'amplificateur ou mélangeur.

3. Procédé selon la revendication 1, **caractérisé en outre en ce que** la fréquence du signal de test est située en dehors de la bande passante de l'amplificateur ou mélangeur.

4. Procédé selon la revendication 1, **caractérisé en outre en ce que** l'étape de compensation est exécutée numériquement dans un processeur (130) de signal.

5. Procédé selon la revendication 4, **caractérisé en outre par**
la mesure de la modulation d'amplitude du signal RF avant l'étape de compensation, ce qui aboutit à un signal. RF à détection AM ; et en ce que
l'étape de compensation est effectuée sur ledit signal RF à détection AM.

6. Procédé selon la revendication 5, **caractérisé en outre en ce que** les étapes de mesure des modulations d'amplitude du signal RF et du signal de test sont exécutées par l'utilisation d'un équipement analogique (125, 120) extérieur au processeur (130) de signal.

7. Procédé selon la revendication 5, **caractérisé en outre en ce que** les étapes de mesure des modulations d'amplitude du signal RF et du signal de test sont exécutées numériquement.

8. Procédé selon la revendication 4, **caractérisé en outre par**
la mesure de la modulation de phase du signal RF avant l'étape de compensation, ce qui aboutit à un signal RF à détection PM ; et en ce que
l'étape de compensation est effectuée sur ledit signal RF à détection PM.

9. Procédé selon les revendications 3 et 4, **caractérisé par** les étapes suivantes qui consistent :
à mesurer la relation entre la transmodulation subie par le signal RF et la transmodulation subie par le signal de test lorsqu'ils sont soumis au même signal perturbateur dans l'amplificateur ou mélangeur (105, 310) ;
à stocker ladite relation dans une mémoire accessible au processeur (130) de signal ; et
à utiliser cette relation en combinaison avec le signal de sortie du détecteur AM du signal de test dans l'étape de compensation.

10. Procédé selon la revendication 1, **caractérisé en outre en ce que** l'étape de compensation comprend en outre l'étape de modulation d'amplitude du signal RF amplifié ou mélangé, la modulation d'amplitude appliquée étant déterminée par l'utilisation du signal de sortie du détecteur AM du signal de test.

11. Procédé selon la revendication 10, **caractérisé en outre en ce que** l'étape de modulation d'amplitude est effectuée dans une boucle de commande automatique fermée où le signal de sortie de détecteur AM de signal de test est maintenu à une valeur constante.

12. Procédé selon la revendication 10, **caractérisé en outre en ce que** l'étape de modulation d'amplitude est effectuée par la multiplication du signal RF amplifié ou mélangé par la valeur instantanée de l'inverse de la modulation d'amplitude mesurée du signal de test amplifié ou mélangé.

13. Procédé selon la revendication 1, dans lequel l'amplificateur ou mélangeur (105, 310) est un mélangeur (310) auquel est associé un oscillateur local (305) générant un signal d'oscillateur local, **caractérisé en outre par** l'étape suivante qui consiste :
à mélanger le signal de test au signal d'oscillateur local dans un premier mélangeur (315) de signal de test avant l'application du signal de test au mélangeur (305).

14. Circuit électronique pour la compensation de la transmodulation d'un signal RF, le signal RF étant appliqué à un amplificateur ou mélangeur (105, 310) faisant partie du circuit électronique, le circuit électronique étant **caractérisé par** :
un générateur (110) de signal de test destiné à générer un signal de test devant être appliqué, simultanément au signal RF, à l'amplificateur ou mélangeur (105, 310) ;
un filtre (115) de signal de test pouvant être mis en oeuvre sur une partie extraite du signal RF amplifié ou mélangé pour éliminer par filtrage le signal de test amplifié ou mélangé ;
un détecteur AM (120) du signal de test destiné à détecter le signal de test amplifié ou mélangé à la sortie du filtre de signal de test et à mesurer la modulation d'amplitude du signal de test amplifié ou mélangé, le détecteur AM (120) de signal de test étant capable de générer un signal de sortie de détecteur AM de signal de test représentant la modulation d'amplitude du signal de test amplifié ou mélangé ; et
un moyen (130, 205) de compensation de transmodulation destiné à compenser en transmodulation le signal RF amplifié ou mélangé par l'utilisation dudit signal de sortie du détecteur AM du signal de test.

15. Circuit électronique selon la revendication 14, **caractérisé en outre en ce que** le moyen de compensation de transmodulation comprend un processeur (130) de signal.

16. Circuit électronique selon la revendication 15, **caractérisé en outre par**
un détecteur AM (125) de signal voulu destiné à détecter le signal RF amplifié ou mélangé et à mesurer la modulation d'amplitude du signal RF amplifié ou mélangé, le détecteur AM (125) de signal voulu étant capable de générer et d'envoyer au processeur (130) de signal un signal de sortie de détecteur AM de signal voulu représentant la modulation d'amplitude du signal RF amplifié ou mélangé.

17. Circuit électronique selon la revendication 16, **caractérisé en outre en ce que** le détecteur AM (120) de signal de test et le détecteur AM (125) de signal voulu sont des dispositifs analogiques extérieurs au processeur (130) de signal.

18. Circuit électronique selon la revendication 16, **caractérisé en outre en ce que** le détecteur AM (120) de signal de test et le détecteur AM (125) de signal voulu sont exécutés numériquement.

19. Circuit électronique selon la revendication 15, **caractérisé en outre par**
un détecteur PM (125) de signal voulu destiné à détecter le signal RF amplifié ou mélangé et à mesurer la modulation de phase du signal RF amplifié ou mélangé, le détecteur PM (125) de signal voulu étant capable de générer et d'envoyer au processeur (130) de signal un signal de sortie de détecteur PM de signal voulu représentant la modulation de phase du signal RF amplifié ou mélangé.

20. Circuit électronique selon la revendication 15, dans lequel le générateur (110) de signal de test génère un signal de test d'une fréquence qui est située en dehors de la bande passante de l'amplificateur ou du mélangeur, le circuit électronique étant **caractérisé en outre par**
un dispositif de mémorisation destiné à stocker une relation entre la transmodulation subie par le signal RF et la transmodulation subie par le signal de test lorsqu'ils sont soumis au même signal perturbateur dans l'amplificateur ou mélangeur, ledit dispositif de mémorisation étant accessible au processeur de signal (130).

21. Circuit électronique selon la revendication 14, **caractérisé en outre en ce que** le moyen de compensation de transmodulation comporte un modulateur d'amplitude (205) pouvant être mis en oeuvre sur le signal RF amplifié ou mélangé, la modulation d'amplitude effectuée par le modulateur d'amplitude (205) étant déterminée par l'utilisation du signal de sortie du détecteur AM de signal de test.

22. Circuit électronique selon la revendication 14, **caractérisé en outre en ce que** la modulation d'amplitude effectuée par le modulateur d'amplitude (205) est commandée automatiquement dans une boucle fermée, comportant un amplificateur (210) de boucle de commande, où le signal de sortie du détecteur AM de signal de test est maintenu à une valeur constante.

23. Circuit électronique selon la revendication 14, dans lequel l'amplificateur ou mélangeur (105, 310) est un mélangeur (310) auquel est associé un oscillateur local (305) générant un signal d'oscillateur local, **caractérisé en outre par**
un premier oscillateur (315) de signal de test destiné à mélanger le signal de test au signal d'oscillateur local avant l'application du signal de test au mélangeur (310).

24. Circuit électronique selon la revendication 14, **caractérisé en outre en ce que** l'amplificateur ou mélangeur (105, 310) fait partie d'un récepteur radio.
